# EUROPEAN PATENT APPLICATION

(11) **EP 1 337 137 A1**
(43) Date of publication of application: **20.08.2003**
(21) Application number: 03001207.4
(22) Date of filing: 17.01.2003
(51) Int. Cl.: H05K 7/14

(54) **Enclosure incorporating stiffening bars to support one or more backplanes**

(30) Priority: 19.02.2002 US 78798
(71) Applicant: ALCATEL, 75008 Paris (FR)
(72) Inventor: Bradley, Eddie R., Richardson, Texas 75081 (US); Peel, Melvin G., Plano, Texas 75025 (US)
(74) Representative: Dreiss, Fuhlendorf, Steimle & Becker

(57) **Abstract**

An enclosure and method are described that uses one or more stiffening bars to support one or more backplanes and to help prevent the deflection of the backplane(s) when a plug-in card is inserted into or removed from a connector in one of the backplanes. Three different embodiments of the stiffening bars are described herein including a side backplane stiffening bar, a backplane stiffening bar and a middle backplane stiffening bar.

## Description

### Background of the Invention

### Field of the Invention

The present invention relates in general to electronic packaging and, in particular, to an enclosure that uses one or more stiffening bars to support a backplane and to help prevent the deflection of the backplane when a plug-in card is inserted into or removed from a connector in the backplane.

### Description of Related Art

Besides the desktop-sized and notebook-sized personal computers widely used today in homes, schools and offices, there are so-called industrial computers that are widely used in rugged environments such as an industrial environment and a military environment. Since the industrial computers operate in rugged environments, the industrial computers are designed to fit within an enclosure that is more durable than the enclosures that contain the desktop-sized and notebook-sized personal computers. Currently, there are different specifications and standards for industrial computers and their enclosures one of which is the Peripheral Component Interconnect (PCI) specification. The PCI specification describes an enclosure known as a CompactPCI™ subrack which receives a number of plug-in cards known as CompactPCI™ boards that make-up the industrial computer. More details about the CompactPCI™ subrack and the CompactPCI™ boards that make-up the industrial computer are set forth in the PCI specification the contents of which are incorporated herein by reference.

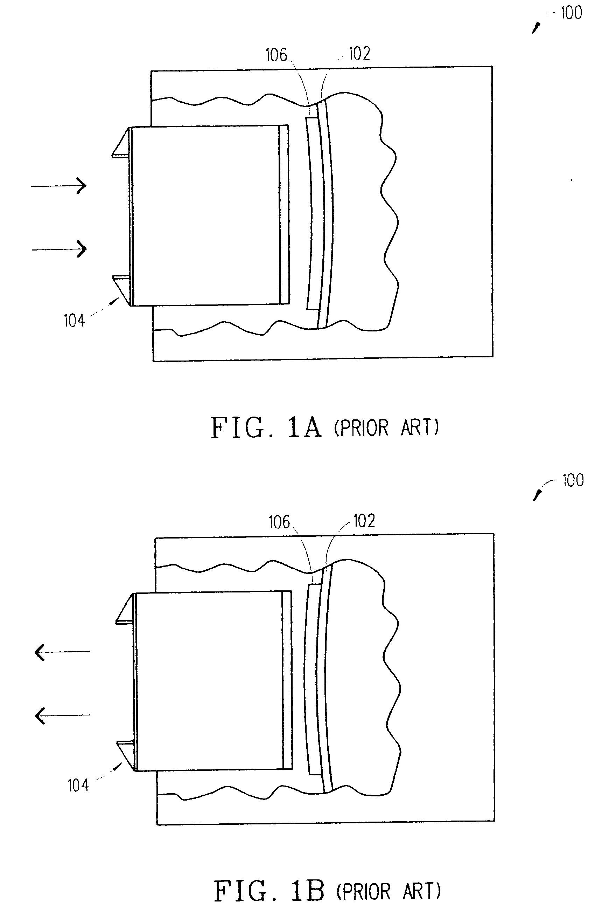

Traditional enclosures such as the CompactPCI™ subrack includes one or more backplanes that have connectors configured to interface with the plug-in cards (e.g., processing cards, signaling cards, power supply cards) that make-up the industrial computer. Unfortunately, the CompactPCI™ subrack supports a backplane at the top and bottom of the backplane which leads to the problematical situation where the backplane would deflect whenever a plug-in card is inserted into or removed from a connector in that backplane. Referring to FIGURES 1A and 1B there are shown cut-away side views of a traditional CompactPCI™ subrack 100 illustrating how a backplane 102 would deflect when a plug-in card 104 is inserted into and removed from a connector 106 in the backplane 102. The deflection of the backplane 102 can lead to the bending of pins in the connector 106 which would make it impossible for the plug-in card 104 to seat properly in the connector 106. Of course, when the plug-in card 104 does not seat properly in the connector 106 then that plug-in card 104 and the industrial computer would not work properly. Accordingly, there is a need for an enclosure that uses one or more stiffening bars to support a backplane and to help prevent the deflection of the backplane when a plug-in card is inserted into or removed from a connector in the backplane. This need and other needs are addressed by the enclosure and method of the present invention.

### BRIEF DESCRIPTION OF the Invention

The present invention includes an enclosure and method that uses one or more stiffening bars to support one or more backplanes and to help prevent the deflection of the backplane(s) when a plug-in card is inserted into or removed from a connector in one of the backplanes. Three different embodiments of the stiffening bars are described herein including a side backplane stiffening bar, a backplane stiffening bar and a middle backplane stiffening bar.

### BRIEF DESCRIPTION OF THE DRAWINGS

A more complete understanding of the present invention may be had by reference to the following detailed description when taken in conjunction with the accompanying drawings wherein:
FIGURE 1A (PRIOR ART) is a cut-away side view of a traditional enclosure illustrating how a backplane would deflect when a plug-in card is inserted into a connector in the backplane;
FIGURE 1B (PRIOR ART) is a cut-away side view of the traditional enclosure illustrating how the backplane would deflect when a plug-in card is removed from the connector in the backplane;
FIGURE 2 is a perspective view of the front of an enclosure incorporating a side backplane stiffening bar in accordance with the present invention;
FIGURE 3 is a perspective view of the back of the enclosure shown in FIGURE 2 incorporating the side backplane stiffening bar;
FIGURE 4 is a side view illustrating in greater detail the side backplane stiffening bar shown in FIGURES 2 and 3;
FIGURE 5 is a perspective view of the back of an enclosure incorporating two backplane stiffening bars in accordance with the present invention;
FIGURES 6A and 6B are views illustrating in greater detail one of the backplane stiffening bars shown in FIGURE 5;
FIGURE 7 is a perspective view of the back of an enclosure incorporating a middle backplane stiffening bar in accordance with the present invention;
FIGURES 8A-8E are different views illustrating in greater detail the middle backplane stiffening bar shown in FIGURE 7;
FIGURE 9 is a perspective view of the back of an enclosure incorporating the side backplane stiffening bar, two backplane stiffening bars and the middle backplane stiffening bar respectively shown in FIGURES 4, 6 and 8; and
FIGURE 10 is a flowchart illustrating the basic steps of a preferred method for supporting one or more backplanes located in the enclosure shown in FIGURES 2, 5, 7 or 9.

### DETAILED DESCRIPTION OF THE DRAWINGS

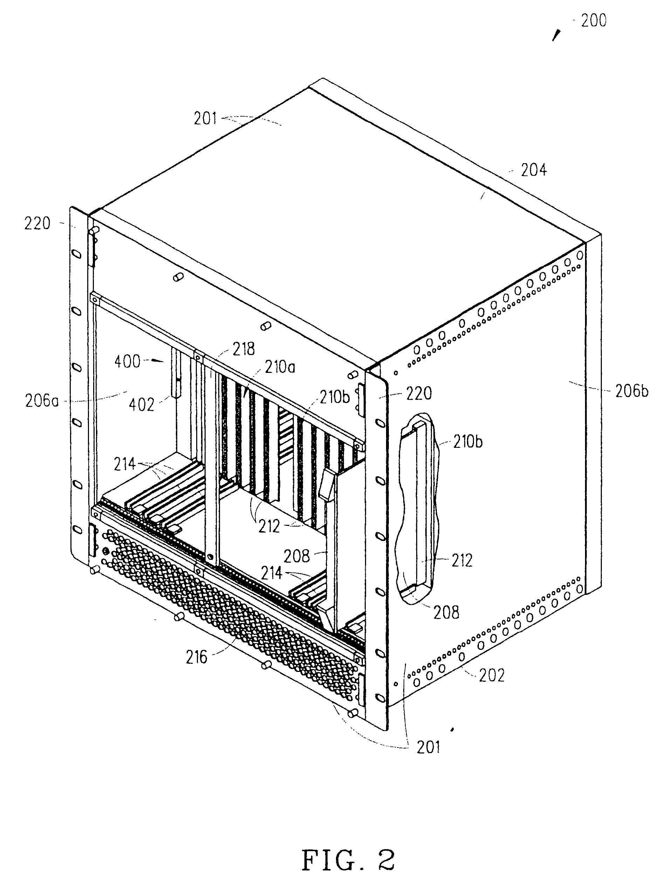

Referring to FIGURES 2-10, there are disclosed in accordance with the present invention an enclosure 200, 500, 700 and 900 and preferred method 1000 that uses one or more stiffening bars 400, 600 and 800 to support two backplanes and to help prevent the deflection of one of the backplanes when a plug-in card is inserted into a connector or removed from the connector in that backplane.

Although the enclosure 200, 500, 700 and 900 is described as being similar to a CompactPCI™ subrack that is built in accordance with the Peripheral Component Interconnect (PCI) Specification, it should be understood that any type of enclosure incorporating one or more backplanes can use the stiffening bars 400, 600 and 800 of the present invention. Accordingly, the enclosure 200, 500, 700 and 900 and the preferred method 1000 should not be construed in a limited manner.

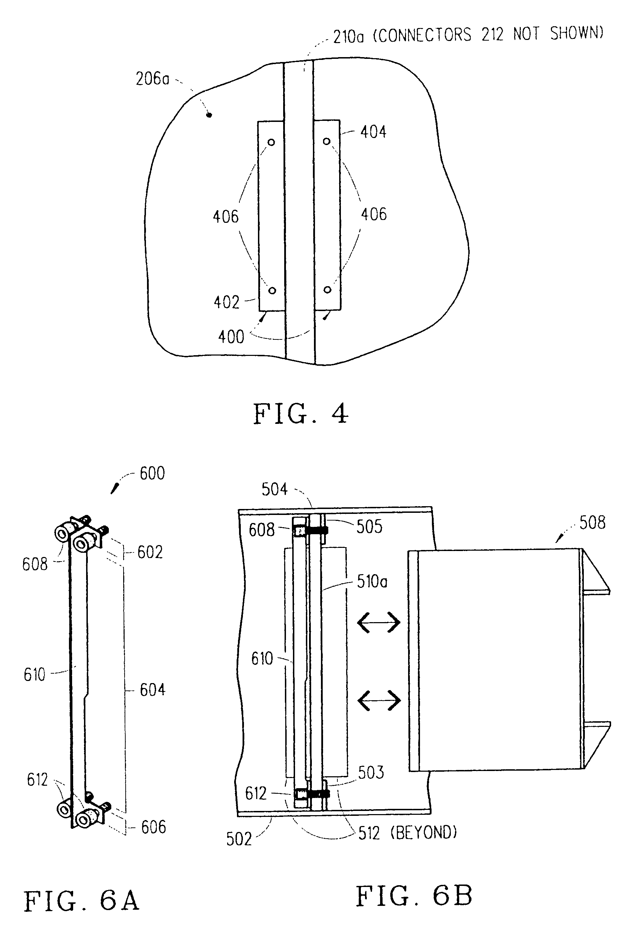

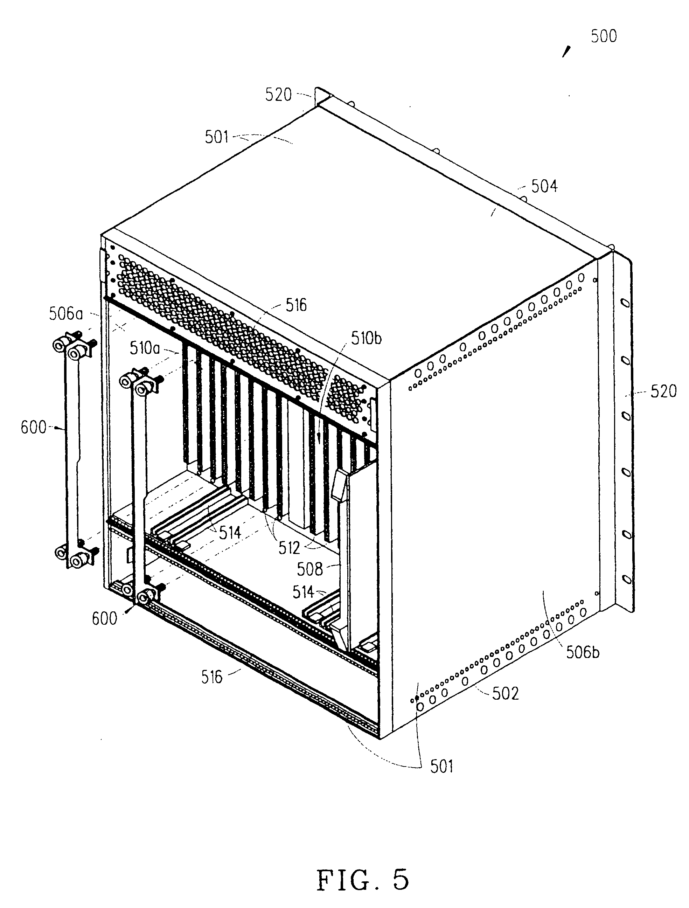

Referring to FIGURES 2-3, there are respectively shown perspective views of the front and the back of the enclosure 200 incorporating a side backplane stiffening bar 400. For clarity, a detailed discussion about the side stiffening bar 400 is provided below with respect to FIGURE 4 after a brief discussion about the various components of the enclosure 200.

The enclosure 200 includes a frame 201 having a bottom side 202, a top side 204 and two opposite and spaced side walls 206a and 206b. The two side walls 206a and 206b extend from the bottom side 202 and the top side 204 to define therebetween an interior space for accommodating the plug-in cards 208 (only one shown) that make-up the industrial computer (not shown). The enclosure 200 also supports one or more backplanes 210 (two backplanes 210a and 210b are shown) at the top and bottom of the backplanes 210a and 210b. Each backplane 210a and 210b includes a series of connectors 212. The plug-in cards 208 depending on their size are designed to slide on one or two guide rails 214 so they can interact with one of the connectors 212 in the backplanes 210a and 210b. The plug-in card 208 shown is sized to slide on an upper and lower guide rail 214. In operation, each backplane 210a and 210b electrically couples a number of the plug-in cards 208 to create the industrial computer. There are a wide variety of plug-in cards 208 including, for example, power cards, processor cards, timing distribution cards and signaling cards.

The enclosure 200 can also include certain components such as, for example, air ducts 216, a central support bracket 218 and various tabs 220 each of which are known in the industry. Therefore, for clarity, the description provided in relation to the enclosure 200 omits the components not necessary to understand the present invention. It should be understood that the size of the enclosure 200 in the preferred embodiment conforms to the PCI specification, but the enclosure 200 can be any size.

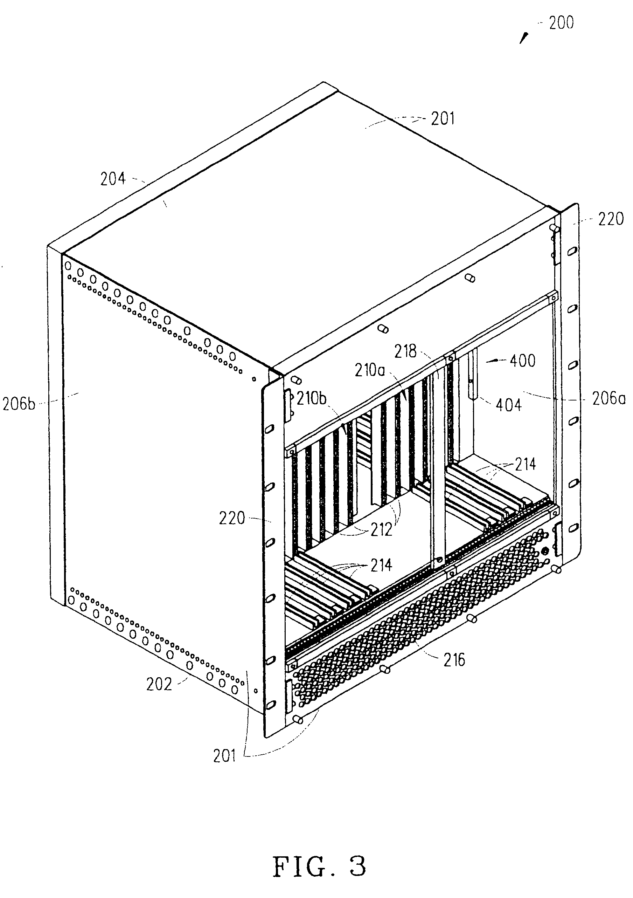

Referring to FIGURE 4, there is a side view illustrating in greater detail the side backplane stiffening bar 400. The side backplane stiffening bar 400 includes a first bar 402 and a second bar 404 (shown as rectangular bars 402 and 404). The first bar 402 is attached to one of the side walls 206a of the frame 201 and is located in front of one of the backplanes 210a (see FIGURE 2). The second bar 404 is attached to the same side wall 206a of the frame 201 and is located in back of backplane 210a (see FIGURE 3). Generally, the first bar 402 and the second bar 404 are attached via screws 406 to the side wall 206a after the backplane 210a is installed within the enclosure 200. The first bar 402 and the second bar 404 are also preferably located at the end of the backplane 210a that receives the plug-in card 208 known as the power card (not shown-but is typically the plug-in card 208 located next to the stiffening bar 400). Thus, the first bar 402 and the second bar 404 can help support the backplane 210a and also help to substantially prevent the backplane 210a from deflecting when the plug-in card 208 (e.g., power card) is inserted into or removed from the connector 212 in the backplane 210a.

Referring to FIGURE 5, there is a perspective view of a back of the enclosure 500 incorporating two backplane stiffening bars 600. For clarity, a detailed discussion about one of the backplane stiffening bar 600 is provided below with respect to FIGURE 6 after a brief discussion about the various components of the enclosure 500.

Enclosure 500 includes a frame 501 having a bottom side 502, a top side 504 and two opposite and spaced side walls 506a and 506b. The two side walls 506a and 506b extend from the bottom side 502 and the top side 504 to define therebetween an interior space for accommodating the plug-in cards 508 (only one shown) that make-up the industrial computer (not shown). The enclosure 500 also supports one or more backplanes 510 (two backplanes 510a and 510b are shown) at the top and bottom of the backplanes 510a and 510b. Each backplane 510a and 510b includes a series of connectors 512. The plug-in cards 508 depending on their size are designed to slide on one or two guide rails 514 so they can interact with one of the connectors 512 in the backplanes 510a and 510b. The plug-in card 508 shown is sized to slide on an upper and lower guide rail 514. In operation, each backplane 510a and 510b electrically couples a number of the plug-in cards 508 to create the industrial computer. There are a wide variety of plug-in cards 508 including, for example, power cards, processor cards, timing distribution cards and signaling cards.

The enclosure 500 can also include certain components such as, for example, air ducts 516, a central support bracket (not shown) and various tabs 520 each of which are known in the industry. Therefore, for clarity, the description provided in relation to the enclosure 500 omits the components not necessary to understand the present invention. It should also be understood that the size of the enclosure 500 in the preferred embodiment conforms to the PCI Specification, but the enclosure 500 can be any size.

Referring to FIGURES 6A and 6B, there are different views illustrating in greater detail one of the backplane stiffening bars 600. The backplane stiffening bar 600 is preferably constructed from one piece of material and includes a top portion 602, a middle portion 604 and a bottom portion 606.

The top portion 602 is attached to a bracket 505 extending from the top side 504 (or to the top side 504 itself or to some other support bracket located near the top side 504) of the frame 501 and to the top of one of the backplanes 510a (see FIGURE 6B). As illustrated, the top portion 602 preferably has the shape of a "T" and also has installed therein two captive screws 608. However, the top portion 602 can have a variety of shapes besides the "T" shape and could include one or more captive screws 608. The two captive screws 608 are used instead of regular nuts and bolts to prevent hardware from falling into the enclosure 500.

The middle portion 604 has a front side 610 configured to be located next to or adjacent to a back of the backplane 510a. Essentially, the middle portion 604 and the front side 610 is configured to help support the backplane 510a and to help substantially prevent the backplane 510a from deflecting when the plug-in card 508 is inserted into the connector 512 in the backplane 510a.

Like the top portion 602, the bottom portion 606 is attached to a bracket 503 extending from the bottom side 502 (or to the bottom side 502 itself or to some other support bracket located near the bottom side 502) of the frame 501 and to the bottom of one of the backplanes 510b. As illustrated, the bottom portion 606 preferably has the shape of a "T" and also has installed therein two captive screws 612. However, the bottom portion 606 can have a variety of shapes besides the "T" shape and could include one or more captive screws 612. The two captive screws 612 are used instead of regular nuts and bolts to prevent hardware from falling into the enclosure 500.

Referring back to FIGURE 5, the enclosure 500 is shown to have two backplane stiffening bars 600 that help to support the backplane 510a and help to substantially prevent the backplane 510a from deflecting when the plug-in card 508 is inserted into the connector 512 in the backplane 510a. However, the enclosure 500 may need only one backplane stiffening bar 600 or may need several of the backplane stiffening bars 600 to help support the backplane 510a and to help prevent the backplane 510a from deflecting when the plug-in card 508 is inserted into the connector 512 in the backplane 510a.

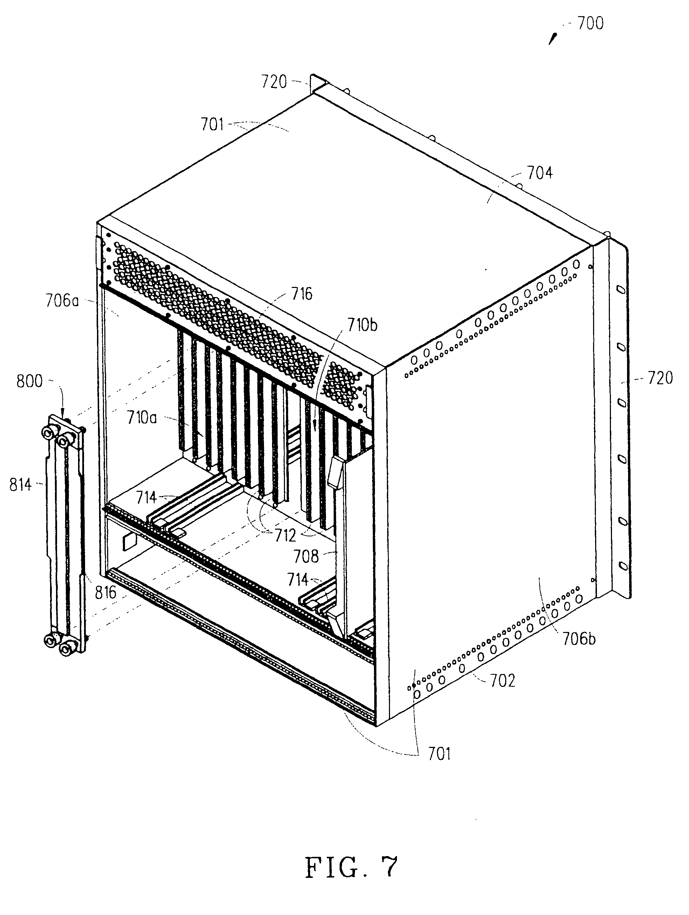

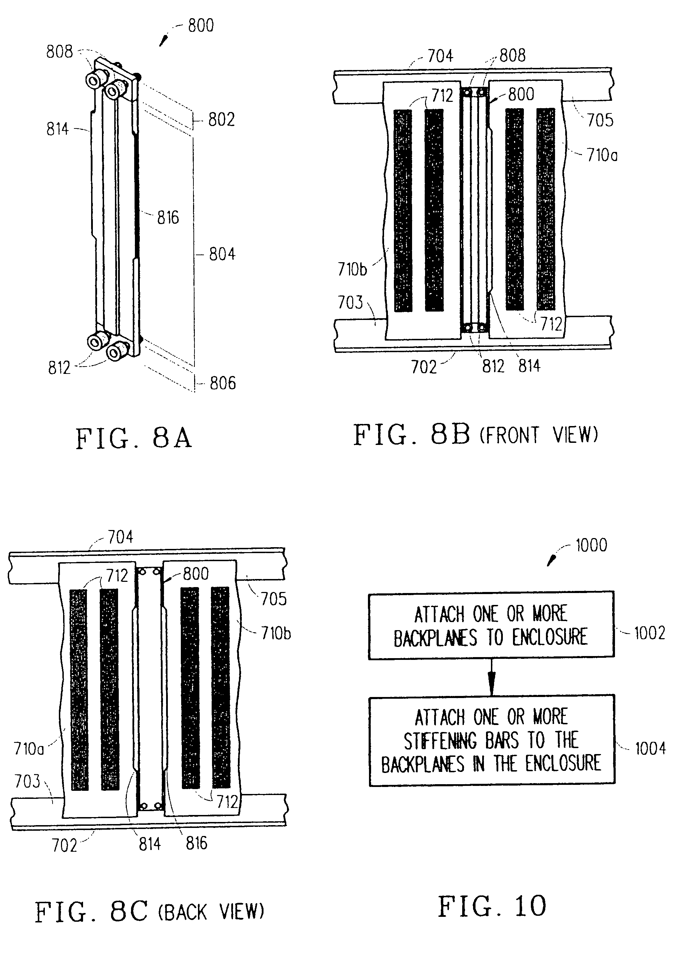

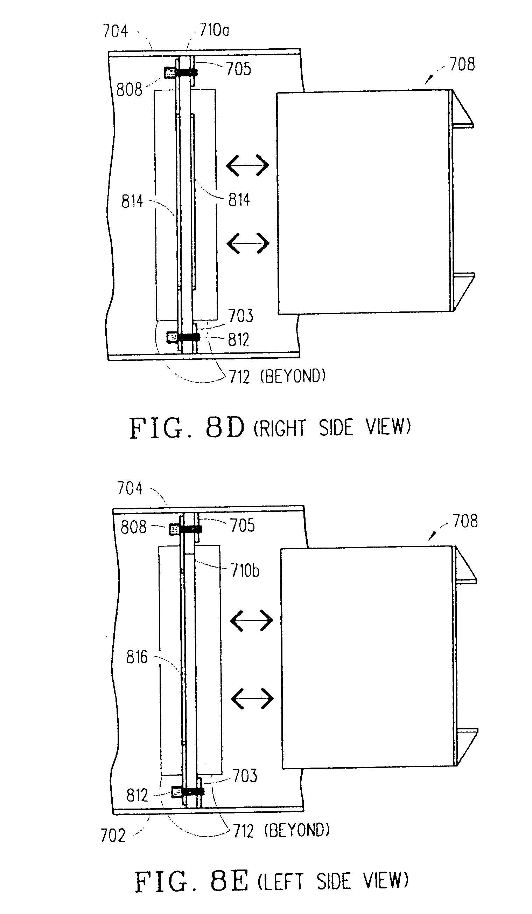

Referring to FIGURE 7, there is a perspective view of a back of the enclosure 700 incorporating a middle stiffening bar 800. For clarity, a detailed discussion about the middle backplane stiffening bar 800 is provided below with respect to FIGURE 8 after a brief discussion about the various components of the enclosure 700.

Enclosure 700 includes a frame 701 having a bottom side 702, a top side 704 and two opposite and spaced side walls 706a and 706b. The two side walls 706a and 706b extend from the bottom side 702 and the top side 704 to define therebetween an interior space for accommodating the plug-in cards 708 (only one shown) that make-up the industrial computer (not shown). The enclosure 700 also supports one or more backplanes 710 (two backplanes 710a and 710b are shown) at the top and bottom of the backplanes 710a and 710b. Each backplane 710a and 710b includes a series of connectors 712. The plug-in cards 708 depending on their size are designed to slide on one or two guide rails 714 so they can interact with one of the connectors 712 in the backplanes 710a and 710b. The plug-in card 708 shown is sized to slide on an upper and lower guide rail 714. In operation, each backplane 710a and 710b electrically couples a number of the plug-in cards 708 to create the industrial computer. There are a wide variety of plug-in cards 708 including, for example, power cards, processor cards, timing distribution cards and signaling cards.

The enclosure 700 can also include certain components such as, for example, air ducts 716, a central support bracket (not shown) and various tabs 720 each of which are known in the industry. Therefore, for clarity, the description provided in relation to the enclosure 700 omits the components not necessary to understand the present invention. It should also be understood that the size of the enclosure 700 in the preferred embodiment conforms to the PCI specification, but the enclosure 700 can be any size.

Referring to FIGURES 8A-8E, there are different views illustrating in greater detail the middle backplane stiffening bar 800. The middle backplane stiffening bar 800 is used in an enclosure 700 that has two backplanes 710a and 710b. In particular, the middle backplane stiffening bar 800 is located between and supports two backplanes 710a and 710b (see FIGURES 8B and 8C).

The middle backplane stiffening bar 800 is preferably constructed from one piece of material and includes a top portion 802, a middle portion 804 and a bottom portion 806. The top portion 802 is attached to a bracket 705 extending from the top side 704 (or to the top side 704 itself or to some other support bracket located near the top side 704) of the frame 701 and to the tops of each of the backplanes 710a and 710b (see FIGURES 8B-8E). As illustrated, the top portion 802 preferably has a square shape and also has installed therein two captive screws 808. However, the top portion 802 can have a variety of shapes including the "T" shape and could include one or more captive screws 808. The two captive screws 808 are used instead of regular nuts and bolts to prevent hardware from falling into the enclosure 700.

The middle portion 804 has on one side a groove 814 and the other side an extension 816. As illustrated in FIGURES 8B-8E, the groove 814 is configured to receive a side of the backplane 710a, and the extension 816 is configured to be located in back of the other backplane 710b. Essentially, the middle portion 804 and in particular the groove 814 and extension 816 are configured to help support the backplanes 710a and 710b and to help substantially prevent the backplanes 710a and 710b from deflecting when the plug-in card 708 is inserted into or removed from one of the connectors 712 in either of the backplanes 710a and 710b.

Like the top portion 802, the bottom portion 806 is attached to a bracket 703 extending from the bottom side 702 (or to the bottom side 702 itself or to some other support bracket located near the bottom side 702) of the frame 701 and to the bottoms of each of the backplanes 710a and 710b (see FIGURES 8B-8E). As illustrated in FIGURE 8A, the bottom portion 806 preferably has a square shape and also has installed therein two captive screws 812. However, the bottom portion 806 can have a variety of shapes including the "T" shape and could include one or more captive screws 812. The two captive screws 812 are used instead of regular nuts and bolts to prevent hardware from falling into the enclosure 700.

It should be noted that a main feature of the middle backplane stiffening bar 800 is that it enables backplane 710b to be removed from the frame 701 while the other backplane 710a remains operational in the frame 701.

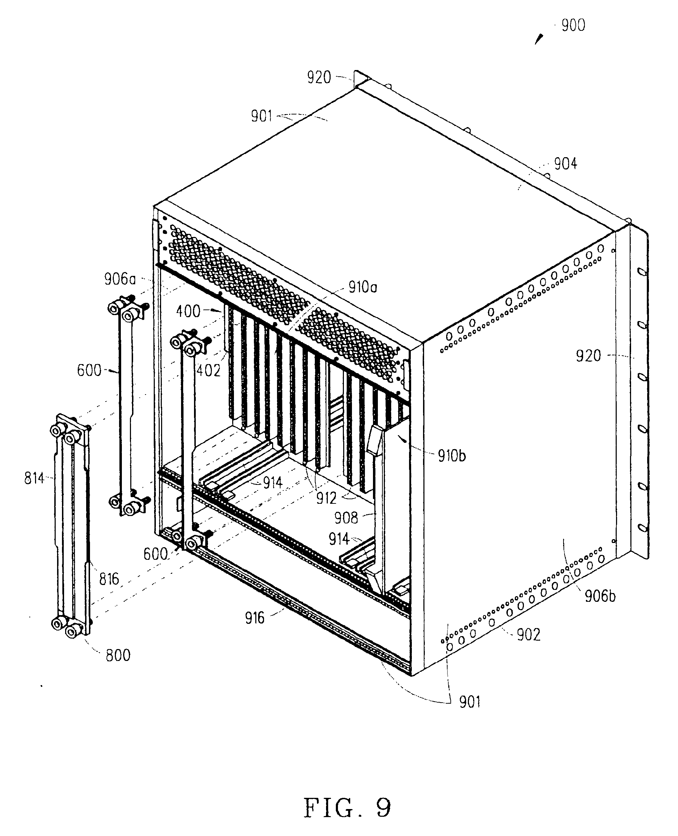

Referring to FIGURE 9, there is a perspective view of the back of an enclosure 900 incorporating the side backplane stiffening bar 400, two backplane stiffening bars 600 and the middle backplane stiffening bar 800. It should be understood that the stiffening bars 400, 700 and 900 can be made from a wide variety of materials including, for example, aluminum, plastic or any type of non-conductive material.

Enclosure 900 includes a frame 901 having a bottom side 902, a top side 904 and two opposite and spaced side walls 906a and 906b. The two side walls 906a and 906b extend from the bottom side 902 and the top side 904 to define therebetween an interior space for accommodating the plug-in cards 908 (only one shown) that make-up the industrial computer (not shown). The enclosure 900 also supports one or more backplanes 910 (two backplanes 910a and 910b are shown) at the top and bottom of the backplanes 910a and 910b. Each backplane 910a and 910b includes a series of connectors 912. The plug-in cards 908 depending on their size are designed to slide on one or two guide rails 914 so they can interact with one of the connectors 912 in the backplanes 910a and 910b. The plug-in card 908 shown is sized to slide on an upper and lower guide rail 914. In operation, each backplane 910a and 910b electrically couples a number of the plug-in cards 908 to create the industrial computer. There are a wide variety of plug-in cards 908 including, for example, power cards, processor cards, timing distribution cards and signaling cards.

The enclosure 900 also includes certain components such as, for example, air ducts 916, a central support bracket (not shown) and various tabs 920 each of which are known in the industry. Therefore, for clarity, the description provided in relation to the enclosure 900 omits the components not necessary to understand the present invention. It should also be understood that the size of the enclosure 900 in the preferred embodiment conforms to the PCI specification, but the enclosure 900 can be any size.

As illustrated, the enclosure 900 incorporates all three of the aforementioned stiffening bars 400, 600 and 800 to help support the backplanes 910a and 910b and to help substantially prevent the backplanes 910a and 910b from deflecting when one of the plug-in cards 908 are inserted into or removed from one of the connectors 912 in either of the backplanes 910a and 910b. However, it should be understood that the enclosure 900 can incorporate different combinations of the stiffening bars 400, 600 and 800 and still support the backplanes 910a and 910b and still help to substantially prevent the backplanes 910a and 910b from deflecting when one of the plug-in cards 908 is inserted into or removed from one of the connectors 912 in either of the backplanes 910a and 910b. For example, the enclosure 900 could incorporate only the side stiffening bar 400 and the middle stiffening bar 800.

Referring to FIGURE 10, there is a flowchart illustrating the basic steps of the preferred method 1000 for supporting one or more backplanes located in an enclosure. For clarity, the description provided below is with reference to the components of enclosure 900. But, it should be understood that the description below could also be written with reference to enclosures 200, 500 or 700.

Beginning at step 1002 and assuming the frame 901 has already been assembled, each of the backplanes 910a and 910b are installed within and attached to the enclosure 900. For example, the tops and bottoms of the backplanes 910a and 910b can be respectively secured to the top side 904 and the bottom side 902 of the enclosure 900. Lastly, at step 1004, one or more of the stiffening bars 400, 600 and/or 800 are attached to the enclosure 900 and the backplanes 910a and 910b. The stiffening bar(s) 400, 600 and 800 are attached to the enclosure 900 and the backplanes 910a and 910b in a manner that substantially prevents the backplanes 910a and 910b from deflecting when one of the plug-in cards 908 is inserted into or removed from one of the connectors 912 in either of the backplanes 910a and 910b.

From the foregoing, it can be readily appreciated by those skilled in the art that the enclosures of the present invention are a marked improvement over the traditional enclosure wherein the backplane would deflect when a plug-in card was inserted into a connector or removed from the connector in the backplane.

Although several embodiments of the present invention have been illustrated in the accompanying Drawings and described in the foregoing Detailed Description, it should be understood that the invention is not limited to the embodiments disclosed, but is capable of numerous rearrangements, modifications and substitutions without departing from the spirit of the invention as set forth and defined by the following claims.

## Claims

1. An enclosure, comprising:
a frame capable of supporting at least one backplane; and
at least one stiffening bar attached to said frame in a manner to substantially prevent the at least one backplane from deflecting when a plug-in card is inserted into a connector or removed from the connector in the at least one backplane.

2. The enclosure of Claim 1, wherein said at least one stiffening bar includes a side backplane stiffening bar comprising:
a first bar attached to a side wall of said frame and located in front of the first backplane; and
a second bar attached to the side wall of said frame and located in back of the first backplane.

3. The enclosure of Claim 1, wherein said at least one stiffening bar includes a backplane stiffening bar comprising:
a top portion attached to a top side of said frame;
a middle portion located next to a back of the first backplane; and
a bottom portion attached to a bottom side of said frame.

4. The enclosure of Claim 3, wherein a plurality of said backplane stiffening bars are used support the backplane.

5. The enclosure of Claim 3, wherein said backplane stiffening bar further includes a plurality of captive fasteners used to connect the top portion and the bottom portion to the frame.

6. The enclosure of Claim 1, wherein said at least one stiffening bar includes a middle backplane stiffening bar comprising:
a top portion attached to a top side of said frame;
a middle portion including:
a groove in which there is received a side of the first backplane; and
an extension located next to a back of the second backplane; and
a bottom portion attached to a bottom side of said frame.

7. The enclosure of Claim 6, wherein said middle backplane stiffening bar further includes a plurality of captive fasteners used to connect the top portion and the bottom portion to the frame.

8. The enclosure of Claim 6, wherein said middle backplane stiffening bar enables the first backplane to be removed from said frame while the second backplane remains operational in said frame.

9. The enclosure of Claim 1, wherein said enclosure is an enhanced CompactPCI subrack.

10. A method for supporting at least one backplane located in an enclosure, said method comprising the steps of:
attaching the at least one backplane to said enclosure; and
attaching at least one stiffening bar to said enclosure in a manner to substantially prevent the at least one backplane from deflecting when a plug-in card is inserted into a connector or removed from the connector in the at least one backplane.

11. The method of Claim 10, wherein said step of attaching at least one stiffening bar further includes attaching a side backplane stiffening bar to said enclosure, said side backplane stiffening bar comprising:
a first bar attached to a side wall of said enclosure and located in front of the first backplane; and
a second bar attached to the side wall of said enclosure and located in back of the first backplane.

12. The method of Claim 10, wherein said step of attaching at least one stiffening bar further includes attaching a backplane stiffening bar to said enclosure, said backplane stiffening bar comprising:
a top portion attached to a top side of said enclosure;
a middle portion located next to a back of the first backplane; and
a bottom portion attached to a bottom side of said enclosure.

13. The method of Claim 12, wherein a plurality of said backplane stiffening bars are used support the backplane.

14. The method of Claim 12, wherein said backplane stiffening bar further includes a plurality of captive fasteners used to connect the top portion and the bottom portion to said enclosure.

15. The method of Claim 10, wherein said step of attaching at least one stiffening bar further includes attaching a middle backplane stiffening bar to said enclosure, said middle backplane stiffening bar comprising:
a top portion attached to said enclosure;
a middle portion including:
a groove in which there is received a side of the first backplane; and
an extension located next to a back of the second backplane; and
a bottom portion attached to said enclosure.

16. The method of Claim 15, wherein said middle backplane stiffening bar further includes a plurality of captive fasteners used to connect the top portion and the bottom portion to said enclosure.

17. The method of Claim 15, wherein said middle backplane stiffening bar enables the first backplane to be removed from said enclosure while the second backplane remains operational in said enclosure.

18. The method of Claim 10, wherein said enclosure is an enhanced CompactPCI subrack.

19. A side backplane stiffening bar used to support and substantially prevent the deflection of a backplane in an enclosure when a plug-in card is inserted into or removed from the connector in the backplane, said side back plane stiffening bar comprising:
a first bar attached to a side wall of said enclosure and located in front of the backplane; and
a second bar attached to the side wall of said enclosure and located in back of the backplane.

20. A backplane stiffening bar used to support and substantially prevent the deflection of a backplane in an enclosure when a plug-in card is inserted into a connector in the backplane, said backplane stiffening bar comprising:
a top portion attached to a top side of said enclosure;
a middle portion located next to a back of the backplane; and
a bottom portion attached to a bottom side of said enclosure.

21. The backplane stiffening bar of Claim 20, wherein a plurality of said backplane stiffening bars are used support the backplane.

22. The backplane stiffening bar of Claim 20, further includes a plurality of captive fasteners used to connect the top portion and the bottom portion to said enclosure.

23. A middle backplane stiffening bar used to support and substantially prevent the deflection of a first backplane and a second backplane in an enclosure when a plug-in card is inserted into or removed from a connector in either the first backplane and the second backplane, said middle backplane stiffening bar comprising:
a top portion attached to a top side of said enclosure;
a middle portion including:
a groove in which there is received a side of the first backplane; and
an extension located next to a back of the second backplane; and
a bottom portion attached to a bottom side of said enclosure.

24. The middle backplane stiffening bar of Claim 23, further comprising a plurality of captive fasteners used to connect the top portion and the bottom portion to the enclosure.

25. The middle backplane stiffening bar of Claim 23, wherein said middle backplane stiffening bar enables the first backplane to be removed from said enclosure while the second backplane remains operational in said enclosure.
